# EUROPEAN PATENT APPLICATION

(11) **EP 3 731 611 A1**
(43) Date of publication of application: **28.10.2020**
(21) Application number: 19170957.5
(22) Date of filing: 24.04.2019
(51) Int. Cl.: H05K 7/20

(54) **IMMERSION COOLING SYSTEM**

(71) Applicant: Hostkey B.V., 1013 JB Amsterdam (NL)
(72) Inventor: Chaianov, Petr, 1013 JB Amsterdam (NL)
(74) Representative: De Vries & Metman

(57) **Abstract**

A single-phase immersion cooling unit is described wherein the cooling unit comprises: one or more first reservoirs positioned in a second reservoir, each of the one or more first reservoirs being adapted to house electrical equipment that produces heat and each of the one or more first reservoirs comprising a base and one or more side faces; a first piping system connected to the one or more first reservoirs and a second piping system connected to the second reservoir, the first and second piping system being connectable to pumping system for pumping a dielectric fluid into the one or more first reservoirs so that at least part of the electrical equipment housed in each of the one or more first reservoirs is at least partially immersed in the dielectric fluid; and, an overflow structure in each of the one or more first reservoirs, the overflow structure being configured to release heated dielectric fluid from a first reservoir if the dielectric fluid in the first reservoir exceeds a predetermined level, the released heated dielectric fluid being collected in the second reservoir.

## Description

### Field of the invention

The invention relates to immersion cooling, and in particular, though not exclusively, to an immersion cooling unit and an immersion cooling system comprising one or more of such immersion cooling units.

### Background of the invention

With the emergence of high-computation intensive technologies such as cloud computing, cryptocurrencies, virtual reality media, deep learning, etc. the need for high performance data centers has grown exponentially. Control of the energy consumption of these data centers has become an important aspect in the design of such data centers and has reintroduced the use of liquid immersion cooling techniques. Liquid immersion cooling refers to techniques in which servers are partially or fully immersed in a dielectric fluid that serves as a coolant for heated server electronics. This technique was initially developed for power transformers and other electrical devices with a complex geometry, but now it has garnered the interest of the computer industry.

Different types of liquid immersion cooling techniques exist. For example, a one phase immersion cooling system typically includes a large tank filled with a dielectric fluid bath in which servers are placed side-by-side. The dielectric fluid is in contact with the heated electronics of the servers so that heat is transferred from the electronics to the dielectric fluid, which is then pumped to a heat exchanger for cooling. The system is operated at atmospheric pressure and the dielectric fluid has a relatively high boiling point or disintegration point so that the coolant remains in the liquid state. Various examples of single-phase immersion cooling systems are described in US8,724,322, US2015/0049432 and WO2019/006437.

A two-phase immersion cooling system relies on a phase change of the coolant (which boils due to a relatively low boiling point) when the coolant contacts the heated electronics. An example of such a system is described in US2017/0064862. The evaporated coolant needs to be condensed using, for example, water-cooled elements so that the condensed liquid can be reused as a coolant. A further type of immersion cooling is the so-called sealed server cooling techniques wherein servers are provided with special liquid channels which are guided through the server and are in thermal contact with the heated electronics so that the heat can be absorbed by the coolant and transported away. An example of such a system is described in US2017/0150649. Two-phased immersion cooling and sealed server cooling require special measures, e.g. a gas-tight environment and dedicated on-board cooling systems respectively, making these techniques quite expensive and less suitable for an efficient and immersion cooling system which is scalable and low-cost.

One-phase immersion cooling techniques are relatively simple but require large amounts of coolant. Another disadvantage is that known single-phase immersion cooling systems are not flexible in the sense that the system is not easy to customize, maintain and repair. Hence, it follows that there is a need in the art for an improved immersion cooling system. In particular, there is a need in the art for a one-phase immersion cooling system that allows efficient cooling of electronics using reduced amounts of coolants. Moreover, there is a need in the art for one-phase immersion cooling systems that have a simple design and that are flexible in application, maintenance and repair.

### Summary of the invention

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system". Functions described in this disclosure may be implemented as an algorithm executed by a microprocessor of a computer. Furthermore, aspects of the present invention may take the form of a computer program product embodied in one or more computer readable media having computer readable program code embodied, e.g. stored, thereon.

In one aspect, the invention may relate to an immersion cooling unit, preferably a single-phase immersion cooling unit, comprising: one or more first reservoirs positioned in a second reservoir, each of the one or more first reservoirs being adapted to house electrical equipment that produces heat and each of the one or more first reservoirs comprising a base and one or more side faces; a first piping system connected to the one or more first reservoirs and a second piping system connected to the second reservoir, the first and second piping system being connectable to a pumping system for pumping a dielectric fluid into the one or more first reservoirs so that at least part of the electrical equipment housed in each of the one or more first reservoirs is at least partly immersed in the dielectric fluid; wherein each of the one or more first reservoirs comprises an overflow structure, the overflow structure being configured to release a heated dielectric fluid from a first reservoir if the level of the dielectric fluid in the first reservoir exceeds a predetermined value, the released heated dielectric fluid then being collected in the second reservoir.

Hence, the immersion cooling unit includes one or more first reservoirs with an overflow structure that are positioned in a larger second (recollection) reservoir. Such a configuration provides efficient use of the dielectric cooling liquid. The use of a plurality of first (equipment) containers which may have dimensions which match the dimensions of the electronics mounted in the equipment reservoir, substantially reduces the amount coolant that is required to cool the electrical equipment. The scheme may save up to 50% of the volume of dielectric liquid when compared with conventional single-phase immersion cooling systems. Moreover, as the heated coolant is immediately released from the equipment container, mixing of hot and cold coolant in the active area is avoided. The overflow structure effectively provides a thermal isolation between the first reservoirs comprising the immersed electronics and the second reservoir comprising the heated dielectric fluid originating from the first reservoirs. The system provides high-efficiency cooling wherein the heated coolant is released via an overflow and drained into collection tank by its own weight.

In an embodiment, the overflow structure may include a plurality of openings at a predetermined height in the one or more side faces of each of the one or more first reservoirs so that if the dielectric fluid in the first reservoir exceeds the predetermined level, the dielectric fluid is released from the first reservoir via the plurality of openings.

In an embodiment, each of the plurality of openings may be provided with a nozzle or a lip that extends outwardly from the side faces so that the heated dielectric fluid is released via the nozzle or the lip. This way, thermal contact between the heated dielectric fluid that is released from the first reservoirs and the relatively cool dielectric fluid at the base of the first reservoirs can be prevented.

In an embodiment, the overflow structure may include one or more pipes positioned vertically in each of the one or more first reservoirs, a first end of each of the one or more pipes being connected to an opening in the first reservoir and the second end of each of the pipes being positioned at a predetermined height in a first reservoir so that if the dielectric fluid in the first reservoir exceeds the predetermined height, the dielectric fluid is released from the first reservoir via the one or more pipes. This embodiment provides the advantage that the overflow structure is fully located inside the first reservoir and the dielectric fluid exits the first reservoir at the base. This way, the risk that the exterior of the side wall of the reservoir becomes dirty is avoided. In order to provide improved thermal isolation between the heated dielectric fluid inside the tube and the relatively cool dielectric fluid contained by the first reservoir (especially towards the base of the reservoir). Locating the overflow structure inside the first reservoir further provides the advantage that the exterior of the first reservoir can be provided with a means for increasing the exterior surface area of the first reservoir so that the reservoir can also be cooled by radiative cooling.

In an embodiment, at least part of the one or more first reservoirs may be provided with one or more cooling fins that attached to the side faces of the one or more first reservoirs.

In an embodiment, the boiling point and/or flash point of the dielectric fluid may be higher than 120 degrees Celsius or the dielectric liquid may have a (kinematic) viscosity of less than 20 centistokes (cSt) at 45 degrees Celsius. In an embodiment, the dielectric fluid may be a silicone oil (e.g. polydimethylsiloxane or a derivative thereof), a mineral oil, a synthetic ether, a fluoro-hydrocarbon, or a silicon hydrocarbon.

In an embodiment, the one or more first reservoirs may comprise a mounting structure for vertically arranging a plurality of IC boards comprising electronics next to each.

In an embodiment, each of the one or more first reservoirs may be releasable connected to the first piping structure. A releasable connector may be used to connect a first reservoir to the piping structure. For example, a flange structure may be used to connect a pipe at the base of a first reservoir with a conduit to the first piping structure. Such a releasable flange connection may be used to connect the base of equipment tanks to the first piping structure. This way, the equipment tanks can be changed and maintenance without service disruption of the system as a whole.

In an embodiment, the cooling unit may further comprise at least one pumping system and one or more heat exchangers, preferably one or more dry coolers, the pumping system pumping heated dielectric fluid from the second reservoir via the second piping system to the one or more heat exchangers for cooling and the pumping system pumping cooled dielectric fluid from the one or more heat exchangers via the first piping system to the one or more first reservoirs.

In a further aspect, the invention may relate to a single-phase immersion cooling system comprising: one or more single-phase immersion cooling units according to any of the embodiments as described above; and, at least one pumping system and a heat exchange system, the pumping system pumping heated dielectric fluid from the one or more single phase immersion cooling units via the second piping system to the heat exchange system for cooling the heated dielectric fluid and the pumping system pumping the cooled dielectric fluid from the heat exchange system via the second piping system to the one or more single-phase immersion cooling units.

In an embodiment, the heat exchange units may be implemented as dry coolers, wherein a blower blows air through a heat exchange structure, e.g. a piping structure, through which the heated fluid is pumped. The heat exchange between the air and the heated piping structure may cause the dielectric fluid to be cooled down to temperatures between 20 and 50 degrees Celsius. Preferably, the heat exchange units are implemented without using water in order to minimize the risk that the dielectric fluid becomes contaminated with water. Water or moisture may chemically react with the dielectric fluid causing the degradation of the fluid.

In an embodiment, the one or more single-phase immersion cooling units and the at least one pump system may be located inside a housing, e.g. a container. In an embodiment, (at least part of) the one or more heat exchangers may be arranged on top of the housing. In other embodiments, (at least part of) the housing may be a part of an existing building or system. The modular design of the system allows the immersion cooling system to be easily integrated in a larger system or structure, such as a factory, a manufacturing facility or a data centre building.

The invention will be further illustrated with reference to the attached drawings which schematically will show embodiments of the invention. It will be understood that the invention is not in any way restricted to these specific embodiments.

### A brief description of the drawings

**Fig. 1** depicts a schematic of a single-phase immersion cooling system.
**Fig. 2** depicts part of an immersion cooling unit according to an embodiment of the invention.
**Fig. 3** depicts an immersion cooling system according to an embodiment of the invention.
**Fig. 4** depicts an equipment reservoir for an immersion cooling system according to an embodiment of the invention.
**Fig. 5** depicts an immersion cooling unit comprising an overflow structure according to an embodiment of the invention.
**Fig. 6** depicts an immersion cooling unit comprising an overflow structure according to another embodiment of the invention.

### Detailed description

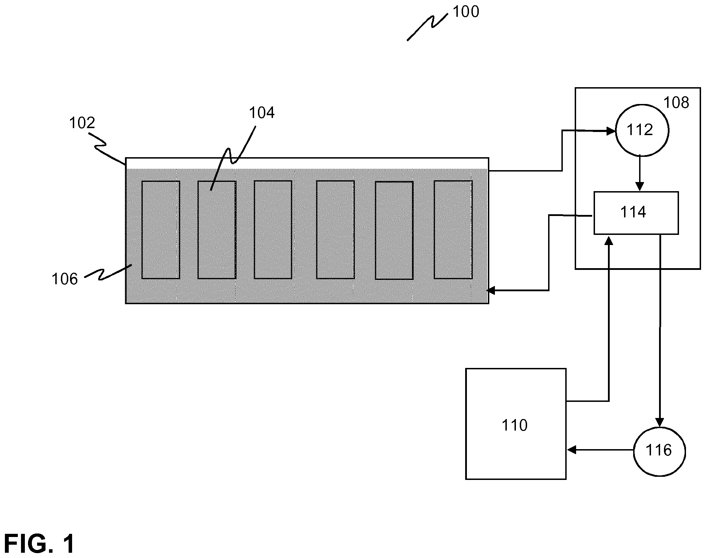

**Fig. 1** depicts a schematic of a single-phase immersion cooling system. In particular, the figure depicts an immersion cooling system **100** including a tank **102** filled with a dielectric liquid **106** and wherein a plurality of electronic systems **104**, e.g. servers, are immersed in the dielectric liquid so that heated electronic components are in thermal contact with the dielectric liquid. The dielectric liquid thus works as a coolant wherein the heated dielectric liquid is cooled based on a cooling system **108** including a pump **112** for pumping the heated dielectric liquid from the tank into a heat exchange system **114**. The cooled dielectric liquid is subsequently injected back into the tank. Further, a water-based cooling unit **110** is connected via a pump to the heat exchange system **114** to cool the heated dielectric liquid. The system depicted in **Fig. 1** requires a substantial amount of dielectric liquid to fill the whole tank so that full immersion of the electronic systems is achieved. Further, it requires the use of water, e.g. a water-based cooling unit, in close vicinity to the dielectric liquid as water can chemically react with the dielectric liquid. These chemical reactions may change the chemical composition of the dielectric liquid so that it can affect the electronic equipment, especially the plastics of the electronic equipment. Additionally, the design does not provide flexibility in terms of customization, maintenance and repair.

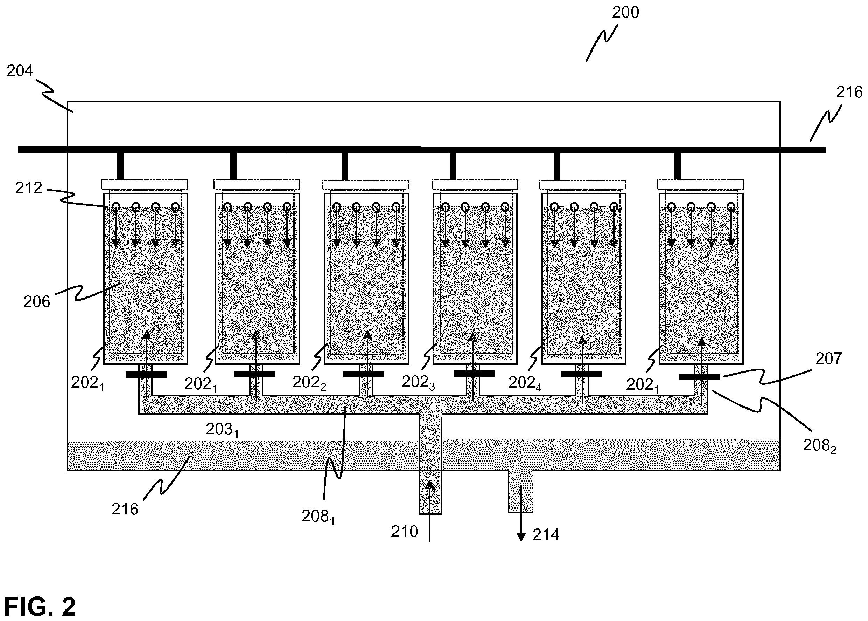

**Fig. 2** depicts part of an immersion cooling unit according to an embodiment of the invention. In particular **Fig. 2** depicts an immersion cooling unit **200** comprising one or more first (equipment) reservoirs 202**₁₋₆** contained (positioned) in a larger second (collection) reservoir **204**. The reservoirs may be made of a suitable material, such as metal, e.g. (stainless) steel, aluminium or a synthetic material, e.g. a plastic and/or a composite material, including a woven fabric such as fibreglass or carbon fibre or the like.

Each equipment reservoir may be configured to contain electronic, heat generating equipment that needs to be cooled, e.g. an integrated circuit (IC) comprising CPUs, RF electronics, power electronics, a graphical processing unit (GPU) or the like. In an embodiment, the interior of each first reservoir may include a mounting structure, e.g. a sliding mechanism, so that IC boards can be vertically arranged, next to each other in the first reservoir. In an embodiment, an equipment reservoir may be implemented as a (substantially) rectangular shaped tank, including a base part, side surfaces and a top part. In another embodiment, an equipment reservoir may have any shape that is necessary to contain the electronics. The top part of the equipment reservoir may have an opening so that electronic equipment can be mounted into the reservoir. Power lines and data lines **216** may connect the electronics to external power supplies and computer systems respectively. In an embodiment, the dimensions of the reservoir may be selected to match the outer dimensions of the electronic equipment. In particular, the dimensions of the equipment reservoir may be selected so that the amount of coolant that flows through the reservoir is capable of absorbing a substantial amount of heat produced by the electronic equipment. Adapting the dimensions of the first reservoirs to the dimensions of the electronic equipment substantially reduces the amount of coolant that is needed for cooling.

As shown in **Fig. 2**, a first piping structure **208_{1,2}** for directing dielectric fluid towards the first reservoirs may comprise at least one main supply line **208₁** comprising a plurality of conduits **208₂** for fluidly connecting the main supply line to each first reservoir. Each conduit may include a valve for closing and opening the fluid connection between the main supply line and the reservoir. A connector **207** provides a releasable connection between a first reservoir and the main supply line. For example, in an embodiment, a flange structure may be used to connect a pipe at the base of a first reservoir with a conduit of the first piping structure. Such a flange connection may be used to removably connect the base of equipment tanks to the main supply line. This way, the equipment tanks can be changed and maintenance can be conducted without service disruption of the system as a whole.

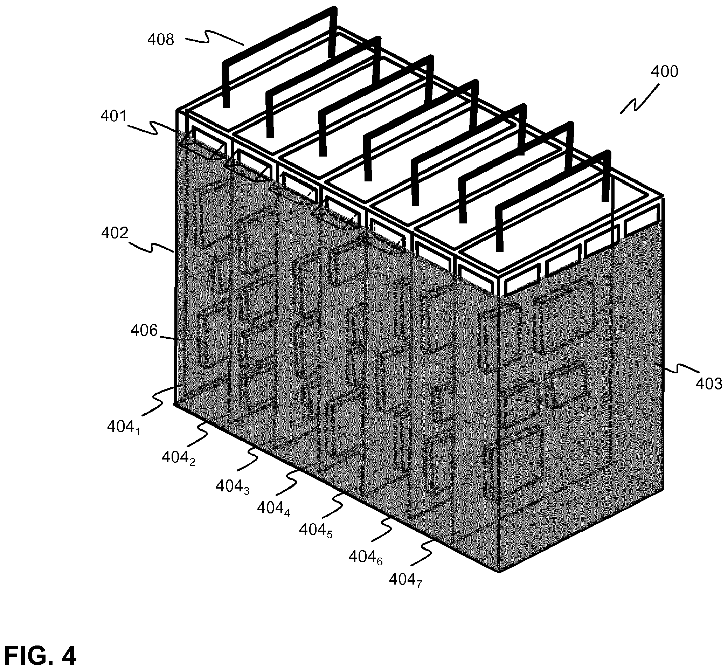

The first piping structure may be part of a circulation system (not shown, an example of a circulation system is described in more detail with reference to **Fig. 4**.) in which a (cooled) dielectric fluid of a relatively low temperature is pumped via the first piping structure into the first reservoirs so that the electronic equipment is immersed in (and in direct contact with) the dielectric fluid. Typically, the cooled dielectric fluid has a temperature lower than 45 degrees Celsius. Depending on the cooling power of the heat exchangers, the cooled liquid may have a temperature of between 10 and 45 degrees Celsius, typically between 30 and 45 degrees Celsius. When the electronic equipment is active, heat generated by the electronics may be absorbed by the dielectric fluid which has a relatively low temperature when it is pumped into the first containers. The pumping action of the pumping system will cause the heated dielectric fluid to flow towards the upper part of the tank. Each of the first reservoirs may comprise an overflow structure **212** allowing heated dielectric fluid at the upper part of the tank to efficiently exit the reservoir.

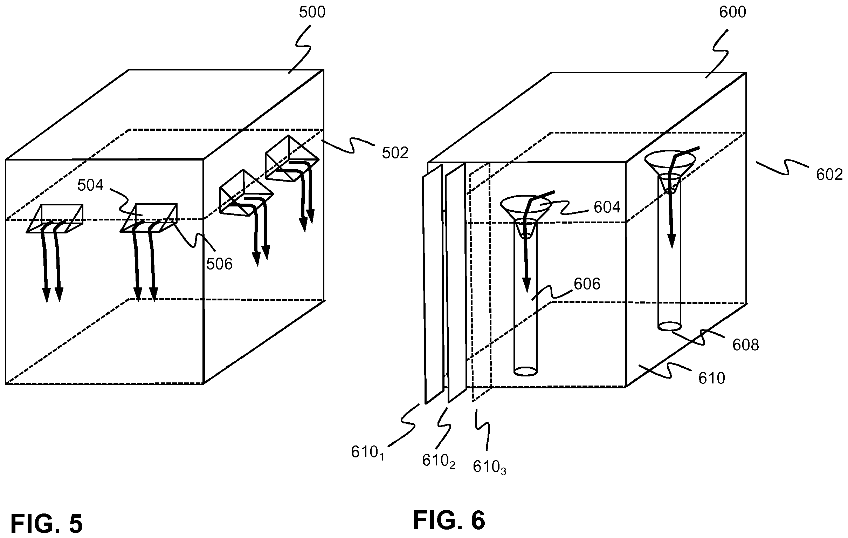

In an embodiment, the overflow structure may include a plurality of holes or slots positioned at a predetermined height under the upper edge of a reservoir. When the dielectric fluid level exceeds the height at which the holes are positioned, the fluid is released via the holes or slots before it reaches the upper edge of the tank. In another embodiment, the overflow structure may include a plurality of slots arranged along the periphery of the upper part of the tank wherein a slot may extent from the upper edge of the tank downwards the sidewalls of the first tank. In an embodiment, the overflow structure may be arranged at each side of the tanks. In an embodiment, each of the openings or slots may include a nozzle or a lip which extends away from the exterior surface of the reservoir. Such an embodiment is depicted in **Fig. 5** wherein a dielectric fluid **502** in a first reservoir can exit the first reservoir via an overflow structure **504** that includes openings in the side walls of the first reservoir, wherein each opening includes a nozzle structure **506**. This way, the heated dielectric fluid may exit the first reservoir without contacting the outside of the reservoir. This way, thermal contact between the heated dielectric fluid and the relatively cool dielectric fluid at the base of the first reservoirs can be prevented.

It is noted that various embodiments of the overflow structure are foreseen without departing from the invention. **Fig. 6** depicts an example of a first reservoir **600** comprising an overflow structure **604,606** according to another embodiment wherein the overflow structure is located inside the first reservoir. In this embodiment, the overflow structure may include a tube **606** positioned inside the reservoir, wherein a first end of the tube may be connected to an opening **608** in the reservoir. In an embodiment, the opening may be an opening in the base **610** of the reservoir. In another embodiment, the opening may be an opening in one of the sides of the reservoir. In further embodiments, the first end of the tube **609** may extend beyond the base or side of the reservoir. The second end of the tube may form the inlet of the overflow structure. In an embodiment, the inlet may have the shape of a funnel or the like. If the surface level of the dielectric fluid exceeds the edge of the funnel, the heated dielectric fluid will enter the funnel-shaped inlet, wherein the fluid will be led into the tube so that it will flow towards the first end of the tube at the base of the reservoir where the fluid will exit the first reservoir. The overflow structures depicted in **Fig. 6** provide the advantage that the overflow structure is fully located inside the first reservoir and the dielectric fluid exits the first reservoir at or under the base. This way, the risk that the exterior of the side wall of the reservoir becomes dirty is substantially reduced.

In order to provide improved thermal isolation between the heated dielectric fluid inside the tube and the relatively cool dielectric fluid contained by the first reservoir (especially towards the base of the reservoir) the tube may include a thermal isolation structure for avoiding thermal contact between the cooled dielectric fluid at the base of the reservoir and the heated dielectric fluid that is flowing through the tube. For example, in an embodiment, a thermally insulated tube may comprise an inner tube and an outer tube wherein the inner tube has a smaller diameter than the outer tube. Locating the overflow structure inside the first reservoir further provides the advantage that the exterior of the first reservoir can be provided with a means for increasing the exterior surface of the first reservoir so that the reservoir can also be cooled by radiative cooling. For example, metal cooling fins **610₁₋₃** may be connected to the side of the first reservoir so that some of the heat generated by the electronics can be transported away using radiative cooling. It is noted that such cooling structures can also be combined with other overflow structures, e.g. an overflow structure such as that described with reference to **Fig. 5**.

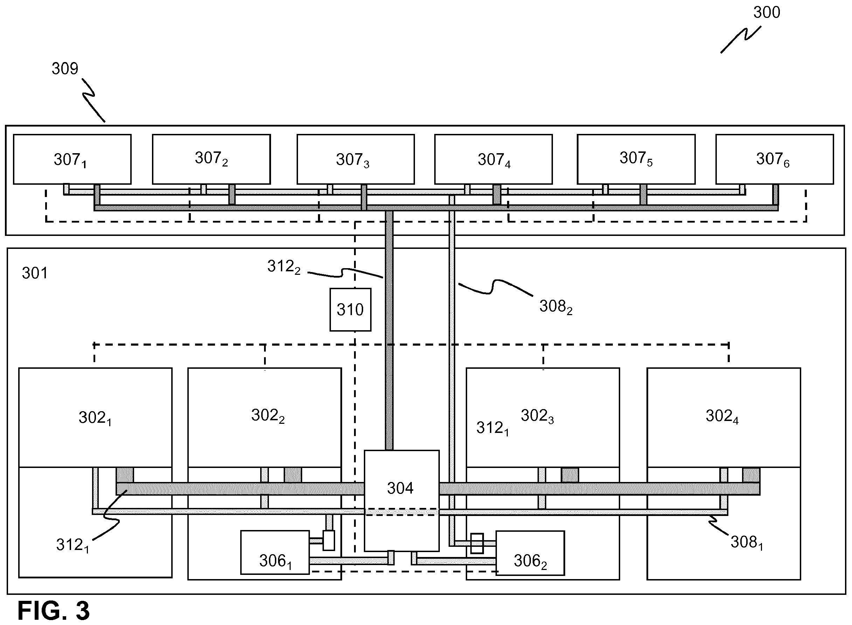

The heated dielectric fluid may exit each of the first reservoirs via the overflow structure, wherein gravity will cause the heated fluid to flow downwards into the second reservoir. The heated fluid is recollected by the second reservoir which is connected to a second piping structure **214** of the circulation system. As will be described in more detail with reference to **Fig. 3**, the recollected heated fluid **216** may be transported via the second piping structure to a cooling system for cooling the fluid so that it can be reused for a further cooling cycle. Thus, in contrast to conventional single-phase immersion cooling systems, the coolant enters the relatively small first (equipment) reservoir at the first end (the base) of the first reservoir, flows from the first end along the heat producing electrical equipment to the second end (the upper part) of the first reservoir, wherein the heated coolant is immediately released from the reservoir via the overflow structure.

The immersion cooling system depicted in **Fig. 2** which includes one or more first reservoirs with an overflow structure positioned in a larger second (recollection) reservoir provides a system that allows efficient use of the dielectric cooling liquid. The use of a plurality of equipment containers as depicted in **Fig. 2** substantially reduces the amount coolant that is required to cool the electrical equipment. The scheme may save up to 50% of the volume of dielectric liquid when compared with conventional single-phase immersion cooling systems. Moreover, as the heated coolant is immediately released from the equipment container, the mixing of hot and cold coolant in the active area is avoided. The overflow structure effectively provides a thermal isolation between the first reservoirs comprising the immersed electronics and the second reservoir comprising the heated dielectric fluid originating from the first reservoirs. The system provides high-efficiency cooling wherein the heated coolant is released via an overflow and drained into a collection tank by its own weight.

Various dielectric liquids may be used as a coolant. In an embodiment, the dielectric liquid may have a (kinematic) viscosity of less than 20 centistokes (cSt) at 45 degrees Celsius. In an embodiment, the boiling point and/or flash point may be higher than 120 degrees Celsius. In an embodiment, a silicone oil (e.g. polydimethylsiloxane or a derivative thereof) may be used as a coolant. In other embodiments, a mineral oil, a synthetic ether, a fluoro-hydrocarbon, or a silicon hydrocarbon may be used as a coolant. In a further embodiment, the coolant may comprise an anti-oxidant for inhibiting oxidation of the coolant. Fluids that may be suitable as a coolant include PMS-5 (polydimethylsiloxane with a viscosity of 5-10 cSt), MIDEL 7131 (a synthetic ester transformer oil) and/or Flutec liquids.

Several immersion cooling units of **Fig. 2** may be part of an immersion cooling system as depicted in **Fig. 3**. As shown in this figure, in an embodiment, the system may comprise a housing **301** in which a plurality of immersion cooling units **302₁₋₄** are installed. The housing may be a container that is specially designed for housing the whole system. In other embodiments, (at least part of) the housing may be a space within a pre-existing building or system. The modular design of the system allows the immersion cooling system to be easily integrated into a larger system or structure, e.g. a factory, a manufacturing facility or a data centre building.

Each immersion cooling unit may include a plurality of first reservoirs located in a second reservoir wherein each of the first reservoirs may comprise electronics that is cooled by a dielectric fluid as described in detail with reference to **Fig. 2****,** **5** and **6**. The immersion cooling system may include a circulation system including a pumping system **304,306_{1,2}** connected to a first piping structure **308_{1,2}** and a second piping structure **312_{1,2}** for circulating the dielectric fluid from the immersion cooling units towards a heat exchanging system **309** and from the heat exchanging system back towards the immersion cooling units. The pumping system may include one or more pumps **306_{1,2}** and a collection tank **304**.

The first piping structure may connect the output of the heat exchange system via the pumping system to the input of the cooling units. In particular, a first part of the first piping structure **308₁** may connect the outputs of the heat exchange units to a first pump **306₁** of the pumping system and a second part **308₂** of the first piping structure may connect the first pump to the input of the immersion cooling units so that cooled dielectric fluid may be pumped into the first reservoirs of each of the immersion cooling units.

Similarly, the second piping structure may connect the output of the cooling units via the pumping system to the input of the heat exchange system. In particular, a first part of the second piping structure **312₁** may connect the output of the cooling units to the reservoir **304** and a second pump **306₂** and a second part of the second piping structure may connect the second pump to the input of the heat exchange units **307₁₋₆** of the heat exchange system. This way, the dielectric fluid that is cooled by the heat exchange units may be pumped by the pumping system via the first piping structure to the input of the immersion cooling units. A second piping system collects heated dielectric fluid that is returned at the output of the immersion cooling units. The pumping system pumps the heated fluid towards the heat exchange units for cooling the fluid before it pumped back into the first reservoirs.

In an embodiment, the heat exchange units may be implemented as dry coolers, wherein a blower blows air through a heat exchange structure, e.g. a piping structure, through which the heated fluid is pumped. The heat exchange between the air and the heated piping structure will cause the dielectric fluid to be cooled down to temperatures of between 20 and 50 degrees Celsius. Preferably, the heat exchange units are implemented without using water in order to minimize the risk that the dielectric fluid becomes contaminated with water. Water may chemically react with the dielectric fluid causing the degradation of the fluid.

The immersion cooling system may comprise a controller **310** for controlling the pump system and the heat exchangers. In an embodiment, the controller may be implemented as a switchboard for manually controlling the system. In another embodiment, the controller may be implemented as a computer, e.g. one or more computer-controlled PLCs. The controller may be connected to sensors (temperature sensors, moisture sensors, etc.) that are mounted in the immersion cooling units, the pump system and the heat exchangers for collecting data associated with the cooling process and to use the data to control the cooling process. For example, the fans or blowers of the heat exchange units may be controlled by the controller based on sensor information.

**Fig. 4** depicts a schematic of an equipment reservoir for immersion cooling according to an embodiment of the invention. As shown in this figure, the reservoir may comprise a mounting structure for vertically arranging a plurality of IC boards **404₁₋₇** comprising electronics modules **406** next to each other. The equipment reservoir may comprise an overflow structure **401**. In this embodiment, the overflow structure comprises holes arranged at a predetermined height on the side faces of the reservoir. The holes enable the release of the dielectric fluid, in particular the heated dielectric fluid that rises to the upper part of the reservoir due to convection. Different implementations of the overflow structure are possible. One side of an IC card may be provided with a covering structure so that when the IC card is mounted (vertically) in the reservoir the covering structure at least partly covers the top of the reservoir. The covering structure may comprise openings allowing cables to enter and exit a reservoir. This way, arranging a plurality of IC cards comprising a covering structure will result in the top of the reservoir being covered. This way, electrical cables and wiring can be kept clean from dielectric fluid. In a further embodiment, the top of the reservoir may be sealed with a sealing structure. The use of the first reservoirs allow efficient and 'clean' handling of the electronic equipment, keeping all contacts and handles dry. Further, the dimensions of the first reservoir may be selected according to the specific circumstances, e.g. the dimensions may be selected such that the reservoir can house a one or more servers, one or more inverters and/or RF equipment. It could be sealed and equipped with electrical connectors/inlets

The terminology used herein is for the purpose of describing particular embodiments only and is not intended to be limiting the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or steps plus function elements in the claims below are intended to include any structure, material, or act for performing the function in combination with other claimed elements as specifically claimed. The description of the present invention has been presented for the purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. A single-phase immersion cooling unit comprising:
one or more first reservoirs positioned in a second reservoir, each of the one or more first reservoirs being adapted to house electrical equipment that produces heat and each of the one or more first reservoirs comprising a base and one or more side faces;
a first piping system connected to the one or more first reservoirs and a second piping system connected to the second reservoir, the first and second piping system being connectable to a pumping system for pumping a dielectric fluid into the one or more first reservoirs so that at least part of the electrical equipment housed in each of the one or more first reservoirs is at least partly immersed in the dielectric fluid;
wherein each of the one or more first reservoirs comprises an overflow structure, the overflow structure being configured to release heated dielectric fluid from a first reservoir if the dielectric fluid in the first reservoir exceeds a predetermined level, the released heated dielectric fluid being collected in the second reservoir.

2. An immersion cooling unit according to claim 1 wherein the overflow structure includes a plurality of openings at a predetermined height in the one or more side faces of the one or more first reservoirs so that if the dielectric fluid in the first reservoir exceeds the predetermined level, the dielectric fluid is released from the first reservoir via the plurality of openings.

3. An immersion cooling unit according to claim 2 wherein each of the plurality of openings is provided with a nozzle or a lip that extends outwardly from the side faces so that the heated dielectric fluid is released via the nozzle or the lip.

4. An immersion cooling unit according to claim 1 wherein the overflow structure includes one or more pipes positioned vertically in each of the one or more first reservoirs, a first end of each of the one or more pipes being connected to an opening in the first reservoir and the second end of each of the pipes being positioned at a predetermined height in a first reservoir so that if the dielectric fluid in the first reservoir exceeds the predetermined level, the dielectric fluid is released from the first reservoir via the one or more pipes.

5. An immersion cooling unit according to any of claims 1-4 wherein at least part of the one or more first reservoirs is provided with one or more cooling fins that are attached to the side faces of the one or more first reservoirs.

6. An immersion cooling unit according to claim 1 wherein the boiling point and/or flash point of the dielectric fluid is higher than 120 degrees Celsius or the dielectric liquid has a (kinematic) viscosity of less than 20 centistokes (cSt) at 45 degrees Celsius.

7. An immersion cooling unit according to any of claims 1-6 wherein the dielectric fluid may be a silicone oil (e.g. polydimethylsiloxane or a derivative thereof), a mineral oil, a synthetic ether, a fluoro-hydrocarbon, or a silicon hydrocarbon.

8. An immersion cooling unit according to any of claims 1-7 wherein one or more first reservoirs comprise a mounting structure for vertically arranging a plurality of IC boards next to each other.

9. An immersion cooling unit according to any of claims 1-8 wherein each of the one or more first reservoirs is releasable from the first piping structure.

10. An immersion cooling unit according to any of claims 1-9 wherein the cooling unit further comprises:
at least one pump system and one or more heat exchangers, preferably one or more dry coolers, the pump system pumping heated dielectric fluid from the second reservoir via the second piping system to the one or more heat exchangers for cooling and the pump system pumping the cooled dielectric fluid from the one or more heat exchangers via the first piping system to the one or more first reservoirs.

11. A single-phase immersion cooling system comprising:
one or more single-phase immersion cooling units according to any of claims 1-9; and, at least one pump system and a heat exchange system, the pump system pumping heated dielectric fluid from the one or more single phase immersion cooling units via the second piping system to the one or more heat exchangers for cooling the heated dielectric fluid and the pump system pumping the cooled dielectric fluid from the one or more heat exchangers via the first piping system to the one or more single-phase immersion cooling units.

12. An immersion cooling system according to claim 11 wherein the one or more single phase immersion cooling units and/or the at least one pump system is located inside a container and, optionally, wherein the one or more heat exchangers are arranged on top of the container.
